# EUROPÄISCHE PATENTSCHRIFT

(11) **EP 4 291 860 B1**
(45) Veröffentlichungstag und Bekanntmachung des Hinweises auf die Patenterteilung: **05.11.2025**
(21) Anmeldenummer: 22703373.5
(22) Anmeldetag: 02.02.2022
(51) Int. Cl.: G01D 21/00, G01D 4/00, G01R 11/24, G01R 22/06

(54) **VERFAHREN ZUM ERKENNEN EINER MANIPULATION EINER SENSOREINHEIT**
METHOD FOR IDENTIFYING MANIPULATION OF A SENSOR UNIT
PROCÉDÉ D'IDENTIFICATION DE MANIPULATION D'UNE UNITÉ DE CAPTEUR

(30) Priorität: 12.02.2021 DE 102021201324
(43) Veröffentlichungstag der Anmeldung: 20.12.2023
(73) Patentinhaber: Schaeffler Technologies AG & Co. KG, 91074 Herzogenaurach (DE)
(72) Erfinder: REUTHER, Achim, 80687 München (DE); SCHIFFERL, Ludwig, 80687 München (DE)
(74) Vertreter: Vitesco Technologies
(86) Internationale Anmeldenummer: PCT/EP2022/052481
(87) Internationale Veröffentlichungsnummer: WO 2022/171502

(56) Entgegenhaltungen:
- WO-A1-2006/027297
- DE-A1- 102014 104 605
- US-A1- 2013 241 540
- US-B1- 9 892 293
- KAMATAGI MS AISHWARYA P ET AL: "Development of Energy Meter Monitoring System (EMMS) for Data Acquisition and Tampering Detection using IoT", 2020 IEEE INTERNATIONAL CONFERENCE ON ELECTRONICS, COMPUTING AND COMMUNICATION TECHNOLOGIES (CONECCT), IEEE, 2 July 2020 (2020-07-02), pages 1 - 6, XP033827871, DOI: 10.1109/CONECCT50063.2020.9198495

## Beschreibung

Die vorliegende Erfindung betrifft ein Verfahren zum Erkennen einer Manipulation einer Sensoreinheit, vorzugsweise einer Sensoreinheit für einen Verbrennungsmotor eines Fahrzeugs.

Sensoreinheiten bestehen üblicherweise aus einer Messeinheit, die dazu ausgebildet ist, eine physikalische Eigenschaft zu messen und ein die physikalische Eigenschaft anzeigendes elektrisches Messsignal zu erzeugen, wie beispielsweise ein Stromsignal, Spannungssignal oder Widerstandssignal, und einer mit der Messeinheit verbundene Steuerungseinheit, die dazu ausgebildet ist, die von der Messeinheit erzeugten Messsignale zu empfangen und zu verarbeiten und an die Messeinheit Steuerungssignale zu senden. Die Sensoreinheit wiederum kann mit einer Steuerungsvorrichtung verbunden sein, die die von der Sensoreinheit aufbereitenden Sensorsignale weiterverarbeitet.

Vermehrt treten jedoch Sensormanipulationen auf, bei denen beispielsweise die originale Messeinheit mit einer anderen Messeinheit ausgetauscht wird, die unter Umständen nicht die Messgenauigkeit aufweist wie die originale Messeinheit. Auch das Ersetzen der originalen Messeinheit mit einem elektrischen Bauteil tritt vermehrt auf, welches jedoch lediglich zufriedenstellende Messignale liefert, die aber nicht die zu messende physikalische Eigenschaft anzeigt. Solche Manipulationen gilt es zu erkennen, da mit diesen auch das Messsignal manipuliert und verfälscht ist.

Die EP 3 581 894 A1 offenbart ein Verfahren, eine Vorrichtung und ein System zur Erfassung eines Manipulationsversuches an einem Sensor eines Fahrzeuges. Dabei wird ein erstes Messsignal eingelesen, das repräsentativ für einen mit dem Sensor erfassten Messwert der ersten Messgröße ist. Ferner wird ermittelt, ob das erste Messsignal außerhalb eines vorgegebenen Nutzbereichs liegt. Wird dabei ermittelt, dass das erste Messsignal außerhalb eines vorgegebenen Nutzbereichs liegt, so wird ein Ausgangssignal ausgegeben, das repräsentativ für einen Manipulationsversuch ist.

Die JP 2011-024354 A beschreibt ein Steuerungsverfahren für einen Motor-Generator. Insbesondere soll dabei erkannt werden, ob ein Drehzahlsensor mit der ECU verbunden ist oder nicht. Dabei wird eine Verbindungsunterbrechung erkannt, wenn ein Erfassungssignal des Drehzahlsensors nicht mehr empfangen werden kann. Zudem ist darin offenbart, dass eine Verbindungsunterbrechung erkannt wird, wenn die ECU ein Pulssignal vom Drehzahlsensor empfängt, das kein kontinuierliches Signal zu vorbestimmten Intervallen ist.

Aus der US 2014/0028463 A1 ist ein System und Verfahren zum Erkennen eines Sensoraustauschs bekannt. Dabei kann die Abwesenheit oder Verbindungsunterbrechung eines Stromsensors von einer Steuerung durch die Rohdaten der angelegten Eingangsspannung ermittelt werden, die aufgrund des Fehlers zufällig oder irregulär sein kann.

Die CN 111 044 684 A zeigt ein System zur Alterungserkennung eines NOx-Sensors. Dabei wird das Signal des NOx-Sensors während vorbestimmter Betriebsbedingungen mit einem Referenzsignal verglichen und bei Abweichen auf eine Alterung geschlossen.

Weiteren bekannten Stand der Technik bilden US 9 892 293 B1 und WO 2006 / 0 027 297 A1.

Es ist eine Aufgabe der vorliegenden Erfindung, eine Manipulation, wie beispielsweise ein Austausch der originalen Messeinheit, einer Sensoreinheit zuverlässig zu erkennen und eine entsprechende Warnung auszugeben.

Diese Aufgabe wird mit einem Verfahren gemäß unabhängigem Anspruch 1 gelöst. Vorteilhafte Ausgestaltungen sind in den Unteransprüchen angegeben.

Der vorliegenden Erfindung liegt im Wesentlichen der Gedanke zugrunde, eine Sensoreinheit dahingehend zu überprüfen, ob die Steuerungseinheit der Sensoreinheit mit einer ordnungsgemäßen und korrekten Messeinheit verbunden ist und nicht ein unerlaubter Austausch der Messeinheit mit einer anderen Messeinheit, wie beispielsweise einem Emulator, ersetzt worden ist. Insbesondere ist es erfindungsgemäß, eine solche Manipulation mittels einem vorbestimmten Diagnosesignal, welches die Steuerungseinheit an die Messeinheit sendet, zu überprüfen und zu analysieren, ob in Erwiderung auf das gesendete Diagnosesignal ein entsprechendes Antwortsignal überhaupt empfangen wird. Damit kann sichergestellt werden, dass eine Manipulation in Form eines unerlaubten Austauschs der Messeinheit nicht stattgefunden hat und somit noch die ordnungsgemäße Messeinheit mit der Steuerungseinheit verbunden ist. Bevorzugt kann zudem beispielsweise in kurzen zeitlichen Abständen das Diagnosesignal gesendet werden, wobei dieser zeitliche Abstand derart gewählt ist, dass innerhalb von zwei zeitlich aufeinanderfolgenden Diagnosesignalen ein Austausch der Messeinheit nicht möglich ist. Bleibt das Empfangen eines Antwortsignals in Erwiderung auf das gesendete Diagnosesignal aus, kann eine Manipulation der Sensoreinheit, insbesondere der Messeinheit, identifiziert werden.

Folglich ist gemäß einem Aspekt der vorliegenden Erfindung ein Verfahren zum Erkennen einer Manipulation einer Sensoreinheit offenbart, die aus einer Messeinheit, die dazu ausgebildet ist, eine physikalische Eigenschaft zu messen, und einer mit der Messeinheit verbundene Steuerungseinheit aufweist, die dazu ausgebildet ist, von der Messeinheit Messsignale zu empfangen und an die Messeinheit Steuerungssignale zu senden. Das erfindungsgemäße Verfahren umfasst ein Senden von mehreren Diagnosesignalen an die Messeinheit mittels der Steuerungseinheit in vorbestimmten periodischen Zeitintervallen, ein Empfangen eines von der Messeinheit in Erwiderung auf das Diagnosesignal erzeugten Antwortsignals an der Steuerungseinheit und ein Erkennen der Manipulation der Sensoreinheit, wenn das Empfangen eines Antwortsignals ausbleibt. Die vorbestimmten periodischen Zeitintervalle sind dabei kürzer als ein vorbestimmtes Montagezeitintervall, während dem ein Austausch der Messeinheit, der Sensoreinheit in kürzester Zeit durchgeführt werden kann.

Insbesondere kann beim Ausbleiben des Empfangens eines Antwortsignals darauf geschlossen werden, dass die ordnungsgemäße Messeinheit nicht mehr vorhanden ist und somit eine Manipulation der Sensoreinheit stattgefunden hat.

Dabei wird sich zu Nutze gemacht, dass die Diagnosesignale mittels der Steuerungseinheit in vorbestimmten periodischen Zeitintervallen gesendet werden, während denen eine Manipulation oder ein Austausch der Messeinheit nicht möglich ist und somit wiederum beim Ausbleiben des Empfangens eines Antwortsignals auf eine Manipulation der Sensoreinheit geschlossen werden kann. Insbesondere bleibt bei einem unerlaubten Austausch der Messeinheit während der Demontage der ordnungsgemäßen und Montage der anderen Messeinheit das Empfangen eines Antwortsignals vorübergehend aus, was die Manipulation der Sensoreinheit anzeigen kann.

Bei den von der Steuerungseinheit an die Messeinheit gesendeten Diagnosesignalen handelt es sich vorzugsweise um einen Stromimpuls, eine Spannung oder ein Wechselspannungssignal mit einer definierten Frequenz.

Bei dem von der Messeinheit in Erwiderung auf das gesendete Diagnosesignal erzeugte Antwortsignal handelt es sich bevorzugt um, bezogen auf die zuvor genannten Beispiele für das Diagnosesignal, eine Spannungsantwort, eine Stromantwort oder ein Wechselspannungssignal mit definierter Amplitude, Bandbreite, Frequenz und/oder Phasenverschiebung.

Vorzugsweise ist die Sensoreinheit dazu ausgebildet, in einem Flugzeug, einem Landfahrzeug, einem Schienenfahrzeug, einem Wasserfahrzeug oder einem Gebäude eingesetzt zu werden. Folglich betrifft das erfindungsgemäße Verfahren sämtliche Sensoreinheiten, die aus einer Steuerungseinheit und einer Messeinheit bestehen und mittels dem eine Manipulation der Sensoreinheit zuverlässig erkannt werden kann.

**In** einer besonders bevorzugten Ausgestaltung handelt es sich bei der Sensoreinheit um eine Sensoreinheit, die in einem Elektrofahrzeug, Hybridfahrzeug oder einem Fahrzeug mit Verbrennungsmotor eingesetzt werden kann. **In** einer besonders vorteilhaften Ausgestaltung handelt es sich bei der Sensoreinheit um einen Abgassensor zum Erfassen der Stickoxid- und/oder Ammoniakkonzentration im Abgastrakt des Verbrennungsmotors des Fahrzeugs, wobei die Messeinheit ein keramikbasiertes Sensorelement aufweist, wie beispielsweise ein yttriumstabilisiertes Zirkonoxid.

**In** einer derartigen bevorzugten Ausgestaltung bildet das yttriumstabilisierte Zirkonoxid samt der daran angebrachten Elektronik die Messeinheit der Sensoreinheit im Sinne der vorliegenden Erfindung. Die Sensor-Steuerungseinheit (= sensor control unit SCU), die mit der Messeinheit elektrisch verbunden ist, bildet die Steuerungseinheit der Sensoreinheit im Sinne der vorliegenden Erfindung.

In einer weiteren vorteilhaften Ausgestaltung des erfindungsgemäßen Verfahrens weist das Fahrzeug eine Fahrzeugsteuerungseinheit zur Steuerung des Verbrennungsmotors auf, die mit der Sensoreinheit, insbesondere der Steuerungseinheit der Sensoreinheit, verbunden ist. Das erfindungsgemäße Verfahren umfasst gemäß einer solchen vorteilhaften Ausgestaltung ferner ein Festlegen eines Sensor-Zeitwerts für die Sensoreinheit, ein Abgleichen der Sensor-Zeitwert mit einem Verbrennungsmotor-Zeitwert des Fahrzeugs und ein Erkennen einer Manipulation der Sensoreinheit, wenn der Sensor-Zeitwert vom Verbrennungsmotor-Zeitwert um mehr als einen Zeitschwellenwert abweicht.

Sollte nämlich die Sensoreinheit von der Fahrzeugsteuerungseinheit elektrisch getrennt werden und dann eine Manipulation stattfinden, würde sowohl das Senden des Diagnosesignals als auch das Empfangen eines in Erwiderung darauf erzeugten Antwortsignals ausbleiben, was dazu führ, dass die Manipulation der Sensoreinheit nicht länger zuverlässig erkannt werden kann. Jedoch würde durch das Abklemmen der Sensoreinheit der Sensor-Zeitwerte bzw. Sensor-Zeitstempel nicht mehr synchron mit dem Verbrennungsmotor-Zeitwert bzw. Verbrennungsmotor-Zeitstempel sein und es kann dadurch auf einen potenziellen Fehler bzw. eine Manipulation der Sensoreinheit festgestellt werden. Folglich ist es erfindungsgemäß, dass beim Starten bzw. Inbetriebnehmen der Sensoreinheit die Zeitwerte der Sensoreinheit und des Verbrennungsmotors abgeglichen werden, um ein solches Abklemmen bzw. eine solche Manipulation zuverlässig feststellen zu können.

Das erfindungsgemäße Verfahren ist ferner dazu bevorzugt, auch außerhalb der normalen Betriebszeit der Sensoreinheit durchgeführt zu werden. Das heißt, dass das erfindungsgemäße Verfahren auch dann durchgeführt werden kann, wenn beispielsweise das Fahrzeug stillsteht und ausgeschalten ist, die Sensoreinheit dennoch mit Energie versorgt ist und somit das erfindungsgemäße Verfahren ausgeführt werden kann.

Bevorzugt weist das erfindungsgemäße Verfahren ferner ein Ausgeben einer Warnung auf, die eine Manipulation der Sensoreinheit anzeigt, wenn eine Manipulation der Sensoreinheit erkannt wurde. Insbesondere soll der Benutzer der Sensoreinheit darauf hingewiesen werden, dass eine Manipulation der Sensoreinheit stattgefunden hat. Auch ist es denkbar, die Warnung an eine behördliche Dienstperson auszugeben, die beim Überprüfen der Sensoreinheit eine beabsichtigte, jedoch unerlaubte Manipulation, die zum Teil nicht rechtskonform ist, festzustellen.

Weitere Aufgaben und Merkmale der vorliegenden Erfindung werden dem Fachmann durch Ausüben der vorliegenden Lehre und Betrachten der beiliegenden Zeichnungen ersichtlich, in denen:
- Fig. 1: schematische Ansicht einer Sensoreinheit zeigt, und
- Fig. 2: ein beispielhaftes Ablaufdiagramm eines erfindungsgemäßen Verfahrens zum Erkennen einer Manipulation der Sensoreinheit der Fig. 1 zeigt.

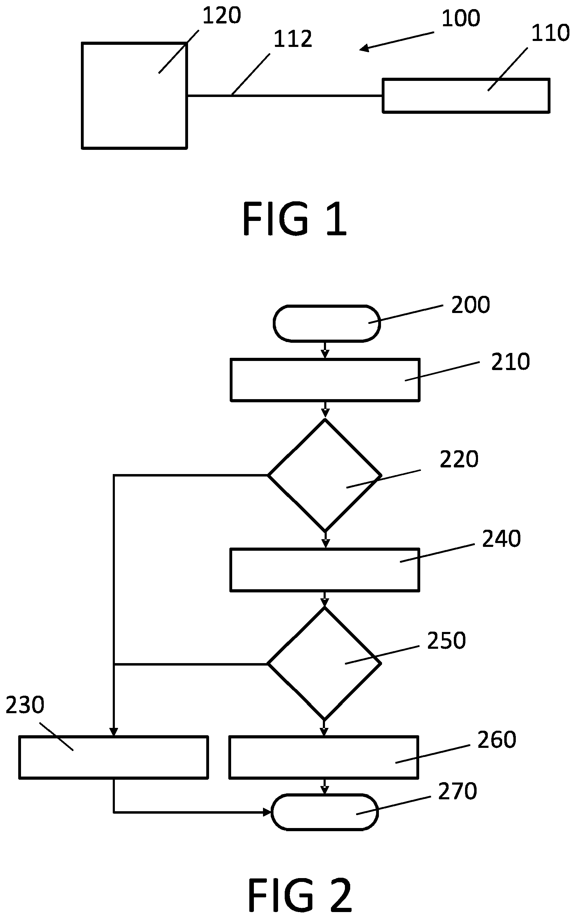

Die Fig. 1 zeigt eine schematische Ansicht einer Sensoreinheit 100. Die Sensoreinheit 100 der Fig. 1 besteht aus einer Messeinheit 110, die mittels einer elektrischen Verbindungsleitung 112 mit einer Steuerungseinheit 120 verbunden ist. Mittels der elektrischen Verbindungsleitung 112 kann die Steuerungseinheit 110 Steuerungssignale an die Messeinheit 110 senden und die Messeinheit 110 wiederum kann die elektrische Verbindungsleitung 112 Messsignale an die Steuerungseinheit 110 zur weiteren Verarbeitung übermitteln.

Die Fig. 2 zeigt ein beispielhaftes Ablaufdiagramm eines erfindungsgemäßen Verfahrens zum Erkennen einer Manipulation der Sensoreinheit 100 der Fig. 1. Insbesondere kann mittels des erfindungsgemäßen Verfahrens ein Austausch der Messeinheit 110 der Sensoreinheit 100 der Fig. 1 mit einer anderen Messeinheit festgestellt werden.

Das Verfahren der Fig. 2 startet beim Schritt 200 und gelangt dann zum Schritt 210, bei dem die Steuerungseinheit 120 zumindest ein Diagnosesignal an die Messeinheit 110 über die elektrische Verbindungsleitung 112 sendet. Beim darauffolgenden Schritt 220 wird überprüft, ob die Steuerungseinheit 120 ein von der Messeinheit 110 in Erwiderung auf das Diagnosesignal erzeugtes Antwortsignal empfängt.

Wird beim Schritt 220 ermittelt, dass ein Empfangen eines Antwortsignals ausbleibt, gelangt das Verfahren zum Schritt 230, an dem eine Manipulation der Sensoreinheit 100 erkannt wird, bevor das Verfahren beim Schritt 270 endet.

Wird jedoch beim Schritt 220 ermittelt, dass die Steuerungseinheit 120 ein Antwortsignal in Erwiderung auf das gesendete Diagnosesignal von der Messeinheit 110 empfängt, gelangt das Verfahren zum Schritt 240, an dem der zuletzt gespeicherte Sensor-Zeitwert ausgelesen wird. In einem darauffolgenden Schritt 250 wird überprüft, ob der ausgelesene Sensor-Zeitwert mit einem externen Zeitwert, wie beispielsweise einem Verbrennungsmotor-Zeitwert, synchron ist. Wird beim Schritt 250 ermittelt, dass der Sensor-Zeitwert von dem Verbrennungsmotor-Zeitwert um mehr als einen Zeitschwellenwert abweicht, gelangt das Verfahren wieder zum Schritt 230, an dem eine Manipulation der Sensoreinheit erkannt wird, bevor das Verfahren wiederum beim Schritt 270 endet.

Der Zeitschwellenwert kann beispielsweise 10 Sekunden, vorzugsweise 5 Sekunden, am bevorzugtesten ungefähr 1 Sekunde betragen. Zusätzlich oder alternativ kann der Zeitschwellenwert in Abhängigkeit der Komplexität der elektrischen Zuleitung ausgewählt werden, wobei der Zeitschwellenwert vorzugweise im ein- oder zweistelligen Sekundenbereich liegen kann.

Wird jedoch beim Schritt 250 bestimmt, dass der Sensor-Zeitwert mit dem Verbrennungsmotor-Zeitwert synchron ist, also der Sensor-Zeitwert vom Verbrennungsmotor-Zeitwert nicht um mehr als einen vorbestimmten Zeitschwellenwert abweicht, gelangt das Verfahren zum Schritt 260, an dem eine nicht manipulierte Sensoreinheit 100 erkannt wird, bevor das Verfahren dann wieder beim Schritt 270 endet.

Das Abgleichen der Sensor-Zeitwert mit dem externen Zeitwert, wie beispielsweise dem Verbrennungsmotor-Zeitwert, gibt Aufschluss darüber, ob die Sensoreinheit 100 in der Zwischenzeit vom zugehörigen System elektrisch abgeklemmt wurde oder nicht. Ist dem der Fall, kann mittels der gespeicherten Zeitwerte und einem Abgleichen derselben miteinander ein solches elektrisches Abklemmen erkannt werden, was ein Indiz für eine Manipulation der Sensoreinheit 100, insbesondere eines unerlaubten Austauschs der Messeinheit 110, sein kann.

## Patentansprüche

1. Verfahren zum Erkennen einer Manipulation einer Sensoreinheit (100), die aus einer Messeinheit (110), die dazu ausgebildet ist, eine physikalische Eigenschaft zu messen, und einer mit der Messeinheit (110) verbundene Steuerungseinheit (120) aufweist, die dazu ausgebildet ist, von der Messeinheit (110) Messsignale zu empfangen und an die Messeinheit (110) Steuerungssignale zu senden, wobei das Verfahren aufweist:
- Senden von mehreren Diagnosesignalen an die Messeinheit (110) mittels der Steuerungseinheit (120) in vorbestimmten periodischen Zeitintervallen, wobei die vorbestimmten periodischen Zeitintervalle kürzer sind als ein vorbestimmtes Montagezeitintervall, während dem ein Austausch der Messeinheit (110) der Sensoreinheit (100) durchgeführt werden kann,
- Empfangen eines von der Messeinheit (110) in Erwiderung auf das Diagnosesignal erzeugten Antwortsignals an der Steuerungseinheit (120), und
- Erkennen einer Manipulation der Sensoreinheit (100), wenn das Empfangen eines Antwortsignal ausbleibt.

2. Verfahren nach Anspruch 1, wobei das Diagnosesignal ein Stromimpuls, eine Spannung oder ein Wechselspannungssignal mit einer definierten Frequenz darstellt.

3. Verfahren nach einem der vorhergehenden Ansprüche, wobei das Antwortsignal eine Spannungsantwort, eine Stromantwort oder ein Wechselspannungssignal mit definierter Amplituden und Phasenverschiebung darstellt.

4. Verfahren nach einem der vorhergehenden Ansprüche, wobei die Sensoreinheit (100) dazu ausgebildet ist, in einem Flugzeug, einem Landfahrzeug, einem Schienenfahrzeug, einem Wasserfahrzeug oder einem Gebäude eingesetzt zu werden.

5. Verfahren nach einem der Ansprüche 1 bis 3, wobei die Sensoreinheit (100) dazu ausgebildet ist, in einem Elektrofahrzeug, einem Hybridfahrzeug oder einem Fahrzeug mit Verbrennungsmotor eingesetzt zu werden.

6. Verfahren nach Anspruch 5, wobei die Sensoreinheit (100) ein Abgassensor zum Erfassen der Stickoxid- und/oder Ammoniakkonzentration im Abgastrakt des Verbrennungsmotors des Fahrzeugs ist, wobei die Messeinheit ein keramikbasiertes Sensorelement aufweist.

7. Verfahren nach einem der Ansprüche 5 und 6, wobei das Fahrzeug eine Fahrzeugsteuerungseinheit zur Steuerung des Verbrennungsmotors aufweist, die mit der Sensoreinheit (100), insbesondere der Steuerungseinheit (120) der Sensoreinheit (100), verbunden ist, wobei das Verfahren ferner aufweist:
- Festlegen eines Sensor-Zeitwerts für die Sensoreinheit (100),
- Abgleichen der Sensor-Zeitwerts mit einem Verbrennungsmotor-Zeitwert des Fahrzeugs, und
- Erkennen einer Manipulation der Sensoreinheit (100), wenn der Sensor-Zeitwert vom Verbrennungsmotor-Zeitwert um mehr als einen Zeitschwellenwert abweicht.

8. Verfahren nach einem der vorhergehenden Ansprüche, wobei das Verfahren auch außerhalb der Betriebszeit der Sensoreinheit (100) durchgeführt wird.

9. Verfahren nach einem der vorhergehenden Ansprüche, ferner mit:
- Ausgeben einer Warnung, die eine Manipulation der Sensoreinheit (100) anzeigt, wenn eine Manipulation der Sensoreinheit (100) erkannt wurde.

## Claims

1. Method for detecting manipulation of a sensor unit (100) that has a measuring unit (110), which is designed to measure a physical property, and a control unit (120), connected to the measuring unit (110), which is designed to receive measurement signals from the measuring unit (110) and to send control signals to the measuring unit (110), the method comprising:
- sending multiple diagnostic signals to the measuring unit (110) by means of the control unit (120) in predetermined periodic time intervals, the predetermined periodic time intervals being shorter than a predetermined installation time interval during which a replacement of the measuring unit (110) of the sensor unit (100) can be carried out,
- receiving at the control unit (120) a response signal generated by the measuring unit (110) in response to the diagnostic signal, and
- detecting manipulation of the sensor unit (100) if a response signal is not received.

2. Method according to Claim 1, the diagnostic signal being a current pulse, a voltage or an AC voltage signal at a defined frequency.

3. Method according to either of the preceding claims, the response signal being a voltage response, a current response or an AC voltage signal with a defined amplitude and phase shift.

4. Method according to one of the preceding claims, the sensor unit (100) being designed to be used in an aircraft, a land vehicle, a rail vehicle, a watercraft or a building.

5. Method according to one of Claims 1 to 3, the sensor unit (100) being designed to be used in an electric vehicle, a hybrid vehicle or a vehicle having an internal combustion engine.

6. Method according to Claim 5, the sensor unit (100) being an exhaust gas sensor for detecting the nitrogen oxide and/or ammonia concentration in the exhaust system of the internal combustion engine of the vehicle, the measuring unit having a ceramic-based sensor element.

7. Method according to either of Claims 5 and 6, the vehicle having a vehicle control unit for controlling the internal combustion engine, which vehicle control unit is connected to the sensor unit (100), in particular the control unit (120) of the sensor unit (100), the method further comprising:
- defining a sensor time value for the sensor unit (100),
- comparing the sensor time value with an internal combustion engine time value of the vehicle, and
- detecting manipulation of the sensor unit (100) if the sensor time value deviates from the internal combustion engine time value by more than a time threshold value.

8. Method according to one of the preceding claims, the method also being carried out outside the operating time of the sensor unit (100).

9. Method according to one of the preceding claims, further comprising:
- issuing a warning indicating manipulation of the sensor unit (100) if manipulation of the sensor unit (100) has been detected.

## Revendications

1. Procédé d'identification d'une manipulation d'une unité de capteur (100), qui comporte une unité de mesure (110), qui est réalisée pour mesure une propriété physique, et une unité de commande (120) reliée à l'unité de mesure (110), qui est réalisée pour recevoir des signaux de mesure de l'unité de mesure (110) et envoyer des signaux de commande à l'unité de mesure (110), le procédé présentant :
- envoi de plusieurs signaux de diagnostic à l'unité de mesure (110) au moyen de l'unité de commande (120) à des intervalles de temps périodiques prédéfinis, les intervalles de temps périodiques prédéfinis étant plus courts qu'un intervalle de temps de montage prédéfini, pendant lequel un remplacement de l'unité de mesure (110) de l'unité de capteur (100) peut être effectué,
- réception sur l'unité de commande (120) d'un signal de réponse généré par l'unité de mesure (110) en réponse au signal de diagnostic, et
- identification d'une manipulation de l'unité de capteur (100) lorsque la réception d'un signal de réponse est inexistante.

2. Procédé selon la revendication 1, le signal de diagnostic constituant une impulsion de courant, une tension ou un signal de tension alternative avec une fréquence définie.

3. Procédé selon l'une des revendications précédentes, le signal de réponse constituant une réponse de tension, une réponse de courant ou un signal de tension alternative avec des amplitudes et un décalage de phase définis.

4. Procédé selon l'une des revendications précédentes, l'unité de capteur (100) étant réalisée pour être utilisée dans un avion, un véhicule terrestre, un véhicule sur rails, une embarcation ou un bâtiment.

5. Procédé selon l'une des revendications 1 à 3, l'unité de capteur (100) étant réalisée pour être utilisée dans un véhicule électrique, un véhicule hybride ou un véhicule avec un moteur à combustion interne.

6. Procédé selon la revendication 5, l'unité de capteur (100) étant un capteur de gaz d'échappement destiné à détecter la concentration d'oxyde d'azote et/ou d'ammoniac dans le conduit de gaz d'échappement du moteur à combustion interne du véhicule, l'unité de mesure comportant un élément de capteur à base de céramique.

7. Procédé selon l'une des revendications 5 et 6, le véhicule comportant une unité de commande de véhicule destinée à commander le moteur à combustion interne, qui est reliée à l'unité de capteur (100), en particulier à l'unité de commande (120) de l'unité de capteur (100), le procédé présentant en outre :
- fixation d'une valeur actuelle de capteur pour l'unité de capteur (100),
- comparaison de la valeur actuelle de capteur à une valeur actuelle de moteur à combustion interne du véhicule, et
- identification d'une manipulation de l'unité de capteur (100) lorsque la valeur actuelle de capteur s'écarte de la valeur actuelle de moteur à combustion interne de plus d'une valeur actuelle de seuil.

8. Procédé selon l'une des revendications précédentes, le procédé étant effectué également en dehors du temps de fonctionnement de l'unité de capteur (100).

9. Procédé selon l'une des revendications précédentes, avec en outre :
- émission d'une alerte, qui indique une manipulation de l'unité de capteur (100) lorsqu'une manipulation de l'unité de capteur (100) a été identifiée.
